# DEMANDE DE BREVET EUROPEEN

(11) **EP 0 749 160 A1**
(43) Date de publication de la demande: **18.12.1996**
(21) Numéro de dépôt: 96401205.8
(22) Date de dépôt: 06.06.1996
(51) Int. Cl.: H01L 23/367

(54) **Procédé de refroidissement d'un circuit intégré monté dans un boîtier**

(30) Priorité: 13.06.1995 FR 9506994
(71) Demandeur: BULL S.A., 78430 Louveciennes (FR)
(72) Inventeur: Fromont, Thierry, 91300 Massy (FR)
(74) Mandataire: Denis, Hervé

(57) **Abrégé**

La chaleur dissipée par le circuit intégré (11) est évacuée dans la plaque (13) pour être transmise dans le boîtier (10) et dans la carte de connexion (12) par l'intermédiaire des bornes d'entrée-sortie (17) du boîtier.

## Description

### Domaine technique

L'invention se rapporte aux procédés de refroidissement d'un circuit intégré monté dans un boîtier destiné à équiper une carte de connexion. Elle a pour objets un tel procédé, un boîtier de circuit intégré et une carte de connexion équipée d'un tel boîtier pour la mise en oeuvre du procédé.

### L'art antérieur

Le refroidissement d'un circuit intégré pose actuellement un grand problème. Il peut atteindre maintenant une taille importante, de l'ordre de 15 à 20 mm de côté et incorporer plusieurs millions de transistors. Il peut donc dissiper plusieurs dizaines de watts en continu, qu'il faut évacuer efficacement et au moindre prix dans le boîtier utilisé pour la connexion du circuit intégré sur une carte de connexion, telle qu'une carte de circuits imprimés.

Il existe plusieurs types bien connus de boîtiers de circuits intégrés. Ils ont en commun le fait de former un support de connexion pour le circuit intégré. Le support de connexion est fait en un matériau électriquement isolant et comprend des conducteurs de liaison entre des bornes intérieures et des bornes extérieures. Les bornes intérieures sont disposées pour être reliées à des bornes respectives d'entrée-sortie du circuit intégré, tandis que les bornes extérieures servent à la liaison extérieure du boîtier à une carte de connexion. Les conducteurs sont généralement placés sur plusieurs couches superposées. Les conducteurs placés sur des niveaux différents sont reliés électriquement entre eux par l'intermédiaire de trous ménagés dans le support de connexion et métallisés. Il peut en être de même entre des conducteurs et des bornes intérieures et extérieures du support. Les bornes extérieures peuvent être disposées latéralement, ou à la périphérie du support, ou encore sur une face du support. Dans ce dernier cas, on utilise couramment comme bornes un réseau maillé de broches connu sous le nom de PGA (Pin Grid Array) ou, de préférence maintenant, le montage en surface par l'intermédiaire de boules disposées en un réseau maillé et désigné couramment par montage BGA (Ball Grid Array) ou SMT (Surface Mount Technology). Les boules sont placées sur des zones conductrices de la surface, ordinairement formées par des extensions en forme de couronnes conductrices des trous métallisés qui les relient aux conducteurs respectifs du support.

On connaît plusieurs types de procédé et de dispositif de refroidissement d'un circuit intégré monté dans un boîtier. Ils se distinguent notamment par le type de fluide utilisé. Le procédé le plus commun utilise l'air, souvent ventilé, comme fluide de refroidissement et met en oeuvre un radiateur comme dispositif de refroidissement. Selon un premier type de boîtier, la face non active du circuit intégré est directement mise en contact avec le dispositif de refroidissement, par l'intermédiaire d'une couche adhésive ou de soudure. Selon un second type, le dispositif de refroidissement est en liaison avec le circuit intégré par l'intermédiaire d'une partie constitutive d'une interface thermique du boîtier. L'interface peut être faite d'une extension du support isolant quand le matériau électriquement isolant est relativement bon conducteur thermique, telle qu'une céramique. Elle peut être aussi faite d'une plaque faite en un matériau bon conducteur thermique, communément le cuivre ou l'aluminium. Elle est placée de façon à venir en contact avec une face du circuit intégré par l'intermédiaire d'une couche adhésive de faible résistance thermique. Le support de connexion entoure ordinairement la plaque en formant avec elle une surface coplanaire. Il est alors fait ordinairement d'un matériau électriquement et thermiquement isolant, tel qu'une céramique, un matériau plastique ou un verre époxy.

Tout dispositif de refroidissement est coûteux, devant être bien adapté au boîtier, à l'énergie thermique dissipée par le circuit intégré, au mode de connexion du boîtier et à l'environnement du boîtier, ainsi qu'au fluide utilisé pour le refroidissement. Le moins cher est le radiateur à ailettes. Mais il faut le monter sur le boîtier de façon que l'interface entre le radiateur et le circuit intégré ait une faible résistance thermique. Il faut encore fixer le radiateur au boîtier. La fixation du radiateur est souvent faite sur la carte de connexion du boîtier et doit quelquefois être amovible. La fixation doit satisfaire à diverses contraintes, telles que des défauts de planéité, de fabrication, des dilatations thermiques différentes entre le radiateur et son support de fixation, etc. Elle doit aussi absorber les chocs mécaniques et les vibrations. En somme, bien que réputé pour être le moins coûteux des dispositifs de refroidissement, son coût inclut les études nécessaires pour bien l'adapter à son contexte, sa fabrication, sa manipulation et sa fixation. En outre, quand le radiateur est fixé sur la carte de connexion du boîtier, la fixation se fait au détriment de la densité des circuits d'interconnexion de la carte et de la densité de connexion des boîtiers sur la carte. Par ailleurs, quand une plaque est utilisée comme interface entre le circuit intégré et le radiateur, les études expérimentales montrent que l'élargissement de la plaque d'évacuation thermique au-delà de la surface du circuit intégré a peu d'effet sur l'évacuation thermique. En fait, le flux de la chaleur du circuit intégré vers le radiateur s'écoule dans la plaque selon un cône légèrement évasé vers la sole du radiateur. La sole du radiateur est souvent épaisse pour diffuser le plus uniformément possible la chaleur aux ailettes du radiateur et occupe une surface maximale possible pour optimiser la surface d'échange thermique entre les ailettes et l'air. Dans ces conditions, la plaque d'interface a une faible épaisseur pour minimiser le volume d'encombrement du boîtier et son coût et, puisqu'il est en outre inutile de l'élargir fortement pour faciliter l'évacuation thermique, elle a une surface sensiblement égale à celle du circuit intégré. En pratique, la plaque a une surface légèrement plus grande de façon que ses bords servent à sa fixation au support de connexion du boîtier.

### L'invention

L'invention a pour but essentiel de faciliter notablement le refroidissement d'un circuit intégré monté dans un boîtier et d'en réduire sensiblement le coût. Grâce à l'invention, l'évacuation thermique dans le boîtier peut être suffisamment efficace pour supprimer l'emploi d'un dispositif de refroidissement tel qu'un radiateur.

L'invention a pour objet un procédé de refroidissement d'un circuit intégré monté dans un boîtier pourvu de bornes extérieures pour la connexion à une carte, consistant à disposer une plaque d'évacuation de la chaleur dissipée par le circuit intégré et caractérisé en ce qu'il consiste à étendre la surface de la plaque de façon à transmettre la chaleur dans le boîtier et dans la carte par l'intermédiaire des bornes extérieures du boîtier.

Il en résulte un boîtier de circuit intégré, comprenant des bornes extérieures pour la connexion du boîtier à une carte et pourvu d'une plaque pour l'évacuation de la chaleur dissipée par le circuit intégré, caractérisé en ce que la surface de la plaque s'étend de façon à transmettre la chaleur dans le boîtier et en ce que le boîtier inclut des moyens pour faciliter l'évacuation de la chaleur dans le boîtier et vers les bornes extérieures du boîtier.

L'invention a donc aussi pour objet corollaire une carte de connexion équipée d'au moins un boîtier de circuit intégré, caractérisée en ce que le boîtier met en oeuvre le procédé et/ou est celui défini précédemment.

Les caractéristiques et avantages de l'invention ressortent de la description qui suit, donnée à titre d'exemple et faite en référence aux dessins annexés.

Dans les dessins :
- la figure 1 est une vue en coupe schématique axiale et partielle, limitée à l'axe central d'un boîtier de circuit intégré conforme à l'invention monté sur une carte de connexion du boîtier ; et
- la figure 2 est une vue similaire à celle de la figure 1, illustrant une variante de réalisation d'un boîtier conforme à l'invention.

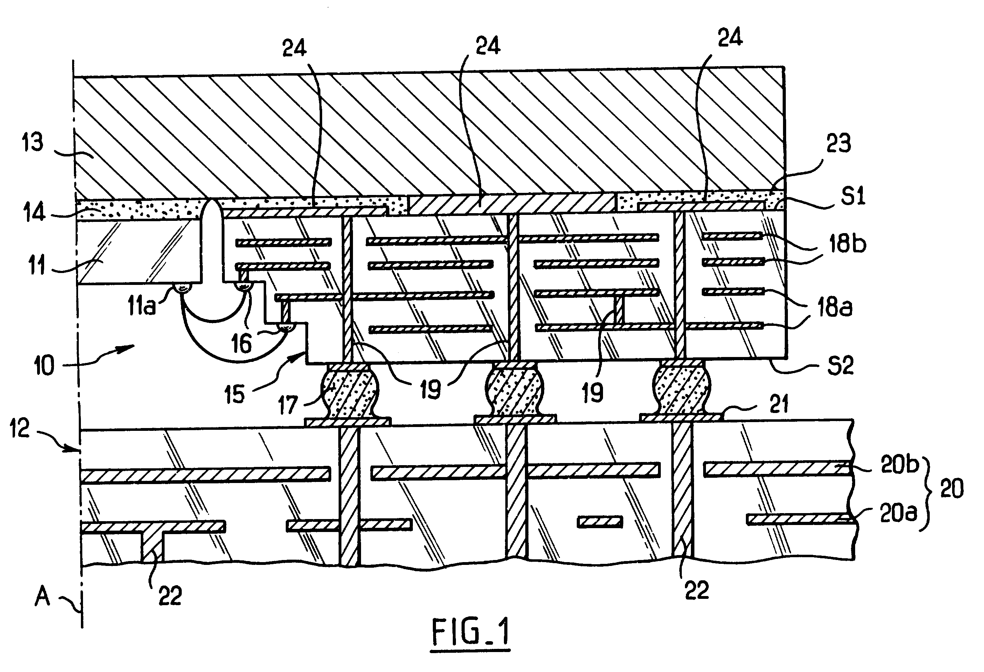

Dans la figure 1 est illustré un boîtier 10 contenant un circuit intégré 11 et monté sur une carte de connexion 12. Le circuit intégré ainsi que la structure du boîtier et de la carte y ont des dimensions volontairement modifiées par rapport aux dimensions réelles afin d'être bien mis en relief. Le circuit intégré 11 a une face active pourvue de bornes d'entrée-sortie 11 a, périphériques dans l'exemple illustré. Le boîtier 10 est pourvu d'une plaque 13 dont la face intérieure est en liaison thermique avec la face non active du circuit intégré 11. La liaison pourrait être directe, mais dans l'exemple illustré elle est faite par l'intermédiaire d'une couche de liaison thermique 14, une couche adhésive ou de soudure par exemple. Le boîtier 10 comprend un support de connexion 15 fait d'un matériau électriquement isolant. Dans l'exemple illustré, le support 15 est un cadre entourant le circuit intégré coaxialement à son axe A et ayant une surface S1 sensiblement coplanaire avec la face non active du circuit intégré. Le support 15 comprend des bornes intérieures 16, des bornes extérieures 17 et des conducteurs 18 reliant les bornes intérieures 16 aux bornes extérieures 17. Les bornes intérieures 16 sont placées à proximité du circuit intégré pour être reliées à ses bornes 11a respectives. Parmi les divers types de liaison connus, la liaison illustrée est faite par l'intermédiaire de fils de liaison selon la technologie appelée communément "wire bonding". Les conducteurs 18 se présentent sous la forme de fils conducteurs 18a et optionnellement d'au moins un plan conducteur 18b. Un plan conducteur sert à transporter l'énergie d'alimentation du circuit intégré en minimisant les effets selfiques. Le support de connexion 15 illustré comprend deux plans conducteurs 18b respectivement représentatifs des deux potentiels d'alimentation et de préférence superposés près du circuit intégré. Les fils 18a forment au moins une couche conductrice, deux couches superposées étant représentées, et transportent les signaux et l'énergie d'alimentation. Le support 15 contient aussi des trous métallisés 19 pour interconnecter des conducteurs 18 de niveaux différents et/ou des bornes extérieures 17 à au moins l'un des conducteurs respectifs 18. Les bornes extérieures 17 illustrées sont placées sur une surface S2 parallèle et opposée à la surface S1 et à la plaque 13 et sont des boules de connexion selon la technologie précitée BGA, disposées selon un réseau maillé et connectées à la carte de connexion 12. De manière classique, chaque boule repose sur une couronne conductrice extérieure autour du trou métallisé correspondant 19 qui relie la boule à des conducteurs 18 du support.

La carte 12 est faite de façon classique d'un matériau isolant incorporant un circuit multicouche d'interconnexion 20. Le circuit 20 illustré comprend des couches superposées de fils conducteurs 20a et de plans conducteurs de potentiel 20b (deux couches respectives étant illustrées dans la coupe partielle de la figure 1), des plages de connexion 21 et des trous métallisés 22 reliant les plages de connexion 21 à des conducteurs 20a, 20b de la carte et reliant souvent aussi des conducteurs de niveaux différents entre eux. Les bornes extérieures 17 du boîtier 10 sont fixées aux plages 21 respectives de la carte.

En pratique, par exemple, le circuit intégré 11 a une épaisseur de l'ordre de 0,5 mm, une taille de l'ordre de 15 à 20 mm de côté, un nombre de l'ordre de 400 à 600 bornes d'entrée-sortie 11a et peut dissiper plusieurs dizaines de watts. Le support 15 a la forme d'un cadre carré de l'ordre de 40 mm de côté extérieur et une épaisseur de l'ordre de 2 mm entre les surfaces S1 et S2 pour une dizaine de couches conductrices. Les couches conductrices 18 ont communément une épaisseur de 35 à 70 µm et sont séparées entre elles par des couches isolantes ordinairement de 100 à 200 µm d'épaisseur. Les bornes intérieures 16 sont souvent réparties sur plusieurs gradins, le plus bas étant au niveau de la surface active du circuit intégré. Les trous métallisés 19 ont un diamètre d'environ 200 µm. Les boules 17 peuvent être au nombre de 300 à 600 et ont couramment un diamètre de l'ordre de 600 à 700 µm. Si la carte 12 est du type à circuits imprimés, elle peut avoir une épaisseur d'environ 3,5 mm et contenir un circuit multicouche 20 d'une trentaine de couches conductrices ayant 30 à 70 µm d'épaisseur, séparées entre elles par des couches isolantes de 100 ou 200 µm. Les trous métallisés 22 ont un diamètre pouvant varier de 0,3 à 5 mm et contiennent une couche de cuivre d'environ 25 µm d'épaisseur.

Pour un boîtier classique, on a vu que la plaque 13 est mince, bonne conductrice thermique, et ses bords dépassent légèrement la surface du circuit intégré de façon à être fixés dans le support 15, et qu'un radiateur est disposé contre la plaque pour constituer une source de froid vers laquelle la chaleur dissipée par le circuit intégré se dirige directement à travers la plaque selon un cône légèrement évasé.

Le procédé de refroidissement conforme à l'invention consiste à étendre la surface de la plaque 13 de façon à transmettre la chaleur dans le boîtier et dans la carte par l'intermédiaire des bornes extérieures 17 du boîtier. Dans l'exemple illustré, la plaque 13 occupe toute la surface de la face supérieure S1 du boîtier 10. Le boîtier 10 n'ayant pas de radiateur, la chaleur fournie par le circuit intégré 11 est forcée à se propager dans toute la surface de la plaque. De préférence, on fera en sorte que la chaleur se diffuse sensiblement uniformément dans toute surface de la plaque, simplement en augmentant son épaisseur pour diminuer sa résistance thermique. La plaque 13 employée dans le boîtier 10 était faite en cuivre et avait une épaisseur sensiblement égale à celle du support, soit 2 mm.

La chaleur conduite par la plaque 13 se transmet ainsi au support 15 à travers une fine couche adhésive 23. Si le support 15 est fait en un matériau électriquement isolant mais relativement bon conducteur thermique, tel qu'une céramique ou l'alumine, le réseau conducteur 18 peut alors recevoir la chaleur de la plaque et la conduire jusqu'aux boules 17. Sinon, ou pour améliorer nettement le transfert de la chaleur par le support 15 dans le cas précédent, on peut utiliser le mode de réalisation illustré dans la figure 1. Les trous métallisés 19 qui conduisent aux boules 17 sont prolongés jusqu'à venir à la surface S1 du support et y former des îlots 24. Bien que normalement séparés entre eux, des îlots peuvent être réunis entre eux s'ils représentent le même signal ou le même potentiel d'alimentation. Ces îlots métalliques captent la chaleur de la plaque, et les trous métallisés 19 la transmettent directement aux boules 17 et indirectement dans les couches conductrices 18. La couche électriquement isolante 23 illustrée isole aussi des îlots 24 de la plaque 13. En pratique, la couche adhésive 14 peut être une colle époxy d'une épaisseur de 100 à 200 µm. La chaleur ainsi transmise aux boules 17 s'évacue dans la carte 12, qui sert ici de source froide et de radiateur. Cela ressort bien de ses caractéristiques précitées et de sa fonction.

Il est clair que les îlots 24 peuvent être électriquement isolants et thermiquement conducteurs. Dans ce cas, ils peuvent venir directement en contact avec la plaque 13. Ils peuvent même être supprimés si le support 15 est fait d'un matériau isolant relativement bon conducteur thermique, ou si seulement au moins la couche isolante formant la surface S1 du support 15 est faite de matériau isolant relativement bon conducteur thermique. Dans ce dernier cas également, des trous métallisés 19 pourraient ne pas être étendus ou métallisés jusqu'à la surface S1. Il serait alors possible aussi que la couche conductrice formée par les îlots ne forme qu'un plan de potentiel, par exemple en remplacement ou en addition au plan 18a. Cette couche extérieure pourrait alors être mise en contact électrique et thermique avec la plaque 13. Bien que la couche adhésive 23 peut entièrement recouvrir le support 15, on comprend donc qu'elle peut aussi être entièrement supprimée, ou en partie seulement quand, comme dans l'exemple illustré, des îlots conducteurs sont plus élevés que les autres îlots et sont mis en contact avec la plaque 13. L'îlot conducteur élevé 24 de l'exemple illustré est connecté à un plan conducteur 18b représentatif d'un potentiel d'alimentation pouvant être nécessaire pour le circuit intégré s'il est du type à transistors à effet de champ. Selon une autre variante, la plaque 13 pourrait servir de substrat pour la fabrication du support. En outre, des trous métallisés 19 intérieurs au support et non connectés aux boules pourraient être prolongés de la même façon, afin d'améliorer encore la transmission de la chaleur par le support.

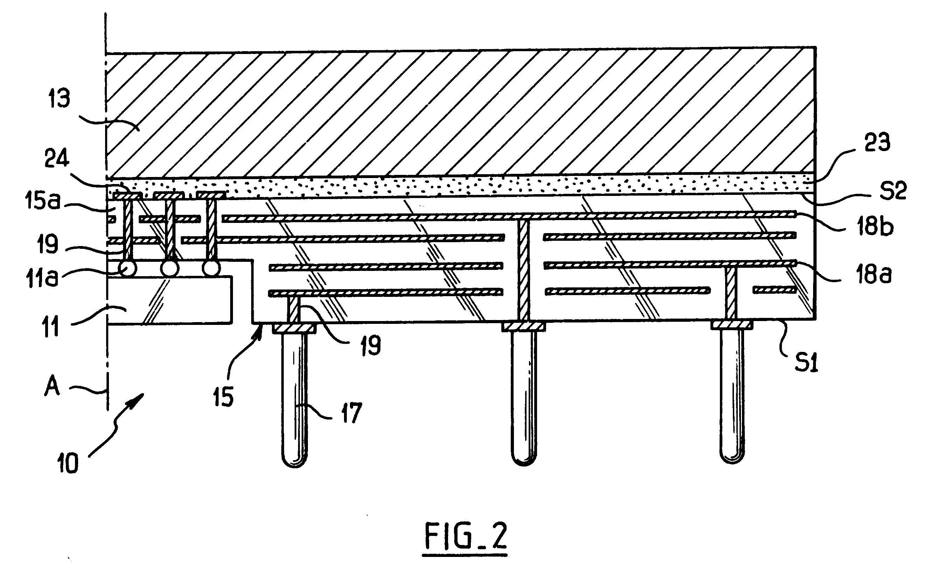

Il existe encore d'autres variantes possibles pour la mise en oeuvre du procédé conforme à l'invention. La figure 2 illustre une première variante de réalisation d'un boîtier conforme à l'invention, vu de façon similaire à celle de la figure 1. Dans cette figure 1, les éléments ayant les mêmes fonctions sont désignés par les mêmes chiffres de référence. Dans le boîtier 10 de la figure 2, le support 15 est un cadre fermant l'ouverture centrale par une partie d'interface thermique 15a formant dans le cadre 15 une cavité pour loger le circuit intégré 11. L'interface thermique 15a peut contenir des couches conductrices 18, comme illustré. Le circuit intégré a sa face active connectée à la partie d'interface thermique 15a selon la technologie appelée "flip chip", par l'intermédiaire de petites boules constituant les bornes d'entrée-sortie 11a. La chaleur dissipée par le circuit intégré s'évacue à travers ces boules 11a et l'interface thermique 15a. Des trous métallisés 19 peuvent y être ajoutés, ainsi que des îlots 24, comme illustré. Cependant, selon cette variante, le support 15 est fait en un matériau électriquement isolant et thermiquement conducteur. Le cadre du support qui entoure le circuit intégré est fait de manière classique, sans extension des trous métallisés vers la surface S1. D'autre part, les bornes extérieures 17 sont des broches. D'une manière générale, on comprend que les bornes extérieures seront de préférence massives, surtout si elles sont peu nombreuses. Par ailleurs, la figure 2 fait apparaître que la couche 23 pourrait être omise si le support 15 était fait directement à partir de la plaque 13.

Selon une autre variante possible, la liaison entre le circuit intégré 11 et la carte 12 pourrait aussi être faite selon la technologie sous le nom de connexion par ruban et bien connue sous le nom de technologie TAB (Tape-Automated Bonding). Compte tenu des exemples déjà décrits, l'homme du métier appliquera sans problème cette technologie au boîtier 10.

D'une manière générale, on peut donc dire que l'invention a pour objet un boîtier 10 de circuit intégré 11, comprenant des bornes extérieures 17 pour la connexion du boîtier à une carte 12 et pourvu d'une plaque 13 pour l'évacuation de la chaleur dissipée par le circuit intégré, la surface de la plaque s'étendant de façon à transmettre la chaleur dans le boîtier et le boîtier incluant des moyens pour faciliter l'évacuation de la chaleur dans le boîtier et vers les bornes extérieures du boîtier. Dans l'exemple illustré, le boîtier est essentiellement constitué par le support de connexion 15 et ne comporte pas de radiateur. Cependant, il peut être avantageux d'utiliser un flux d'air, de préférence ventilé, sur le support et/ou la plaque pour assurer un refroidissement correct du circuit intégré. D'autre part, il est clair que l'invention s'applique à d'autres types de boîtier que ceux décrits précédemment. Selon le type utilisé, le boîtier peut comporter d'autres éléments que le support 15, tels que par exemple un couvercle. Comme cela ressort bien de la description qui précède, les éléments additionnels du boîtier peuvent bien sûr contribuer à l'évacuation de la chaleur. Selon les moyens d'évacuation utilisés, le boîtier peut absorber une partie plus ou moins importante de la chaleur issue de la plaque, l'autre partie étant absorbée par la carte de connexion 12. Les bornes extérieures 17 seront d'autant plus massives qu'elles sont en petit nombre et/ou que la quantité de chaleur à évacuer vers la carte est grande. Elles peuvent donc être différentes des boules et des broches illustrées.

On a vu que les moyens pour faciliter l'évacuation de la chaleur dans le boîtier peuvent consister en ce que ce matériau est au moins en partie thermiquement conducteur. Selon une autre forme supplétive ou additionnelle, dans le cas où des bornes extérieures sont respectivement reliées, à l'intérieur du boîtier, à des traversées conductrices 19, les moyens peuvent être formés d'extensions respectives des traversées vers la plaque. Dans ce cas, qui a été illustré dans la figure 1, l'extension d'au moins une traversée peut comprendre un îlot 24 s'étendant sur une surface S1 du boîtier en vis-à-vis de la plaque et l'îlot peut être mis en contact avec la plaque. Les moyens pour faciliter l'évacuation de la chaleur dans le boîtier peuvent aussi consister en une épaisseur suffisante de la plaque pour obtenir une diffusion sensiblement uniforme de la chaleur vers le boîtier.

Dans le boîtier illustré dans la figure 1, la plaque est séparée du boîtier par une couche électriquement isolante 23. Cependant, la figure fait bien ressortir qu'elle peut aussi être connectée directement à des îlots. Dans le boîtier représenté sur la figure 2, la plaque est séparée du circuit intégré par une couche électriquement isolante pouvant inclure une partie 15a du matériau constituant le boîtier.

## Revendications

1. Procédé de refroidissement d'un circuit intégré (11) monté dans un boîtier (10) pourvu de bornes extérieures (17) pour la connexion à une carte (12), consistant à disposer une plaque (13) d'évacuation de la chaleur dissipée par le circuit intégré, caractérisé en ce qu'il consiste à étendre la surface de la plaque de façon à transmettre la chaleur dans le boîtier et dans la carte par l'intermédiaire des bornes extérieures du boîtier.

2. Boîtier (10) de circuit intégré (11), comprenant des bornes extérieures (17) pour la connexion du boîtier à une carte (12) et pourvu d'une plaque (13) pour l'évacuation de la chaleur dissipée par le circuit intégré, caractérisé en ce que la surface de la plaque s'étend de façon à transmettre la chaleur dans le boîtier et en ce que le boîtier inclut des moyens pour faciliter l'évacuation de la chaleur dans le boîtier et vers les bornes extérieures du boîtier.

3. Boîtier selon la revendication 2, caractérisé en ce qu'étant fait en un matériau électriquement isolant (15a), les moyens consistent en ce que ce matériau est au moins en partie thermiquement conducteur.

4. Boîtier selon la revendication 2 ou 3, caractérisé en ce que des bornes extérieures sont respectivement reliées, à l'intérieur du boîtier, à des traversées conductrices (19) et en ce que les moyens précités comprennent des extensions respectives des traversée vers la plaque.

5. Boîtier selon la revendication 4, caractérisé en ce que l'extension d'au moins une traversée comprend un îlot (24) s'étendant sur une surface (S1) du boîtier en vis-à-vis de la plaque.

6. Boîtier selon la revendication 5, caractérisé en ce que l'îlot est mis en contact avec la plaque.

7. Boîtier selon l'une des revendications 2 à 6, caractérisé en ce que la plaque est séparée du boîtier par une couche électriquement isolante (23).

8. Boîtier selon l'une des revendications 2 à 7, caractérisé en ce que la plaque est séparée du circuit intégré par une couche électriquement isolante pouvant inclure une partie du matériau constituant le boîtier.

9. Boîtier selon l'une des revendications 2 à 8, caractérisé en ce que les moyens précités consistent à rendre l'épaisseur de la plaque suffisante pour obtenir une diffusion sensiblement uniforme de la chaleur vers le boîtier.

10. Carte de connexion (12) équipée d'au moins un boîtier de circuit intégré, caractérisé en ce que le boîtier met en oeuvre le procédé défini par la revendication 1 et est défini par l'une des revendications 2 à 9.
